(19) Europäisches Patentamt
European Patent Office
Office européen des brevets

(11) **EP 4 049 791 A1**

(12) **EUROPEAN PATENT APPLICATION**

(43) Date of publication:
**31.08.2022 Bulletin 2022/35**

(21) Application number: **22158196.0**

(22) Date of filing: **23.02.2022**

(51) International Patent Classification (IPC):
*B24C 1/06 (2006.01)* *B23K 26/354 (2014.01)*
*B33Y 40/20 (2020.01)* *B22F 10/64 (2021.01)*
*B22F 10/66 (2021.01)* *B23K 26/00 (2014.01)*
*B24C 9/00 (2006.01)* *B24C 11/00 (2006.01)*

(52) Cooperative Patent Classification (CPC):
(C-Sets available)
**B24C 1/06; B22F 10/64; B22F 10/66;**
**B23K 26/0093; B23K 26/354; B33Y 40/20;**
B22F 10/28; B22F 2999/00; B24C 9/006;
B24C 11/00 (Cont.)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **26.02.2021 JP 2021029702**

(71) Applicant: **Sintokogio, Ltd.**
**Nagoya-shi, Aichi 450-6424 (JP)**

(72) Inventors:
• **TSUJI, Toshiya**
**Nagoya-shi, Aichi, 450-6424 (JP)**

• **SHIBUYA, Norihito**
**Nagoya-shi, Aichi, 450-6424 (JP)**
• **OKADA, Akira**
**Okayama-shi, Okayama, 700-0026 (JP)**
• **SHINONAGA, Togo**
**Okayama-shi, Okayama, 700-0013 (JP)**
• **WATANABE, Taisei**
**Itami-shi, Hyogo, 664-0864 (JP)**
• **KOBAYASHI, Hiroya**
**Soya-shi, Okayama, 719-1137 (JP)**

(74) Representative: **Hoffmann Eitle**
**Patent- und Rechtsanwälte PartmbB**
**Arabellastraße 30**
**81925 München (DE)**

(54) **SURFACE TREATMENT METHOD AND SURFACE TREATMENT SYSTEM**

(57) A method for surface treatment includes performing blasting (S10) on a surface of a workpiece, and irradiating (S20) the blasted surface of the workpiece with electron beam.

*Fig.1*

EP 4 049 791 A1

**(Cont. next page)**

(52) Cooperative Patent Classification (CPC): (Cont.)

C-Sets
B22F 2999/00, B22F 10/64, B22F 2202/11;
B22F 2999/00, B22F 10/66, B22F 2003/166

**Description**

CROSS-REFERENCE TO RELATED APPLICATION

This application is based on Japanese Patent Application No. 2021-029702 filed with Japan Patent Office on February 26, 2021, the entire contents of which are hereby incorporated by reference.

TECHNICAL FIELD

The present disclosure relates to a method for surface treatment and a surface treatment system.

BACKGROUND

Japanese Unexamined Patent Publication No. 2004-001086 discloses a method for surface treatment for smoothing a mold surface by irradiation with electron beam.

Technical Problem

In the method of Japanese Unexamined Patent Publication No. 2004-1086, it is considered that the surface of a workpiece is smoothed by the melting of the surface of the workpiece. Therefore, there is a possibility that the roughness of the workpiece can be efficiently removed when the surface state of the workpiece can be controlled to be a shape that easily melts by the electron beam. The present disclosure provides a technology capable of efficiently smoothing a workpiece by the irradiation with electron beam.

Solution to Problem

The inventor of the present invention has focused on a fact that blasting can control the surface state with a principle different from that of melting, and has found that the reduction rate of the surface roughness of a workpiece increases when blasting is performed before irradiation with electron beam as compared to a case where only the irradiation with the electron beam is performed. In other words, it has been found that a ratio of decrease of the roughness of the workpiece increases in comparison before and after the electron beam irradiation.

In other words, a method for surface treatment according to one aspect of the present disclosure is a method for surface treatment includes: performing blasting on a surface of the workpiece; and irradiating the blasted surface of the workpiece with electron beam. According to the method for surface treatment, the workpiece can be efficiently smoothed by the irradiation with the electron beam because the reduction rate of the surface roughness of the workpiece increases as compared to a case where only the irradiation with the electron beam is performed.

In one embodiment, the workpiece may be a sintered product of metal powder. In one embodiment, the workpiece may be an additively manufactured product. The roughness of the surface of a sintered product or an additively manufactured product tends to be relatively large. The method for surface treatment can even efficiently cause the surface of a sintered product or an additively manufactured product to be flat.

In one embodiment, a mean width of roughness profile elements of the blasted surface of the workpiece may be less than 770.80 $\mu$m. In this case, the method for surface treatment can cause the reduction rate of the surface roughness of the workpiece to be 20% or more.

A surface treatment system according to another aspect of the present embodiment includes: a blasting apparatus configured to perform blasting on a workpiece; an electron beam irradiation apparatus configured to irradiate the workpiece with electron beam; and a control unit configured to control the blasting apparatus and the electron beam irradiation apparatus. The control unit causes the blasting apparatus to perform blasting on a surface of the workpiece by controlling the blasting apparatus, and causes the electron beam irradiation apparatus to irradiate, with the electron beam, the surface of the blasted workpiece by controlling the electron beam irradiation apparatus. As with the surface treatment apparatus described above, the surface treatment system can efficiently smooth the workpiece by the irradiation with the electron beam as compared to a case where only the irradiation with the electron beam is performed.

Advantageous Effect of Invention

According to the present disclosure, the workpiece can be efficiently smoothed by the irradiation of the electron beam.

BRIEF DESCRIPTION OF DRAWINGS

FIG. 1 is a flowchart illustrating one example of a method for surface treatment according to an embodiment;
FIG. 2 is a schematic view illustrating one example of a blasting apparatus;
FIG. 3 is a schematic view illustrating one example of an electron beam irradiation apparatus;
FIG. 4 is a block diagram illustrating one example of a surface treatment system according to the embodiment;
FIG. 5 is one example of irradiation with electron beam performed on a workpiece;
FIG. 6 is a table showing evaluation results of the surface roughness;
FIG. 7 is a scatter diagram showing the correlation between the RSm (mean width of roughness profile roughness elements) and the Rz (maximum height roughness) reduction rate; and
FIGS. 8A to 8E are cross-section observation results of workpieces before and after the electron beam irradiation.

DETAILED DESCRIPTION

An embodiment of the present disclosure is described below with reference to the drawings. In the description below, the same or equivalent elements are denoted by the same reference characters, and overlapping description is not repeated. Dimension ratios of the drawings do not necessarily match with those described. Terms "up", "down", "left", and "right" are based on the illustrated states and are for convenience.

[Method for surface treatment]

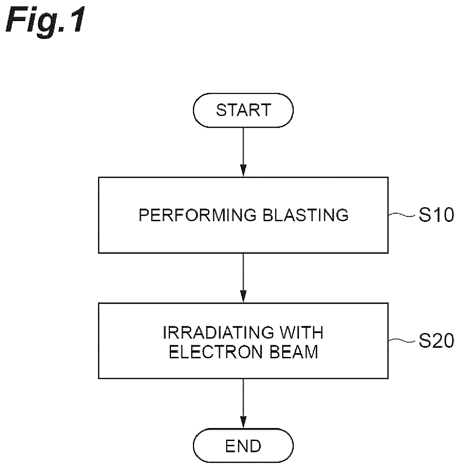

FIG. 1 is a flowchart illustrating one example of a method for surface treatment according to the embodiment. The method for surface treatment illustrated in FIG. 1 is a method of smoothing the surface of a workpiece. The workpiece is a target on which the surface treatment is performed. The workpiece is formed of metal such as iron, aluminum, titanium, stainless steel, copper alloy, or carbon steel, for example. The workpiece may be a sintered product of metal powder. The sintered product is manufactured by sintering metal powder by powder metallurgy. The workpiece may be an additively manufactured product. The additively manufactured product is manufactured by repeatedly irradiating metal powder with laser light. The workpiece may be a casting. The workpiece may be a cutting-worked product. The workpiece may be a forging.
As illustrated in FIG. 1, the method for surface treatment includes performing blasting (Step S10) and irradiating with electron beam (Step S20). The blasting is performed by a blasting apparatus. The irradiating with electron beam is performed by an electron beam irradiation apparatus. First, the outline of apparatus examples used in each step is described.

[Blasting Apparatus]

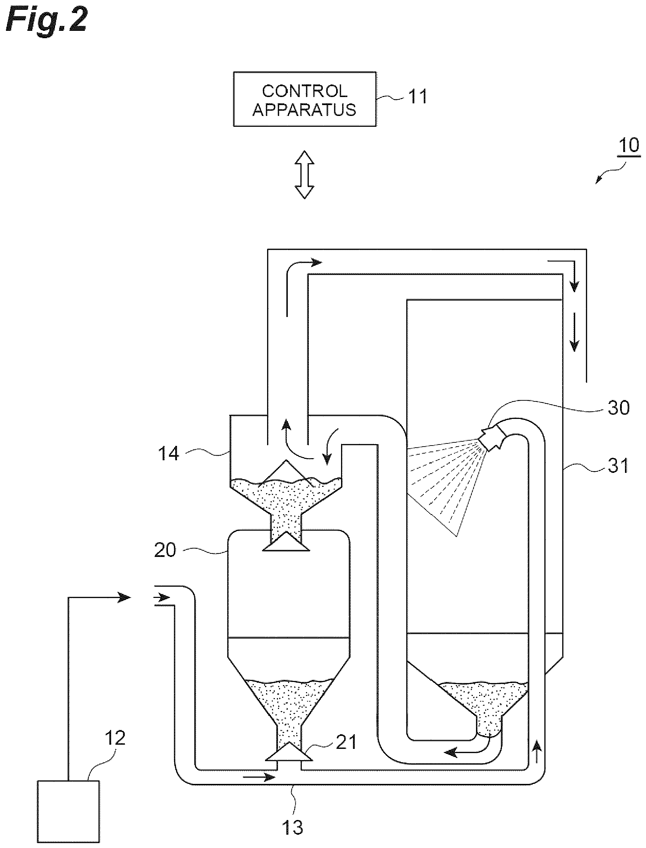

FIG. 2 is a schematic view illustrating one example of the blasting apparatus. Blasting is a treatment method of grinding the surface of the workpiece by projecting an abrasive material. The material of the abrasive material is selected from various materials such as metal, ceramic, glass, resin, and plant-derived substances. Metal is iron, zinc, or stainless steel, for example. Ceramic is alumina, silicon carbide, or zircon, for example. Resin is nylon resin, melamine resin, or urea resin, for example. Plant-derived substances are walnut or peach, for example. The shape of the abrasive material is selected from various shapes such as a spherical shape, a polygonal shape, a cylindrical shape, and an irregular shape. For example, in the case of metal particles, shots, grids, and cut wires can be selected. The shots are spherical particles. The grids are polygonal particles having acute angles. The cut wires are cylindrical shapes or cylindrical shapes with rounded corners.
A blasting apparatus 10 illustrated in FIG. 2 is a direct-pressure-type blasting apparatus. The direct-pressure-type blasting apparatus is a pressurization-type blasting apparatus in other words. As illustrated in FIG. 2, the blasting apparatus 10 includes a storage container 20 and a nozzle 30. The storage container 20 defines a space in which an abrasive material is stored on the inside and stores the abrasive material therein. The abrasive material is supplied to the storage container 20 from the outside. For example, an operator may supply the abrasive material to the storage container 20. The storage container 20 may reuse a part of the abrasive material used in the blasting. In this case, the abrasive material used in the blasting is supplied to the storage container 20 from a classification mechanism 14 described below. The storage container 20 is connected to the nozzle 30 via a fixed quantity supplying unit 21 and a pipe 13. The fixed quantity supplying unit 21 is an apparatus that sends out the abrasive material stored in the storage container 20 to the pipe 13 and is a screw feeder as one example.
A gas supply source 12 that supplies gas is connected to the pipe 13. Examples of the gas supply source 12 include a compressor or a gas cylinder that supplies gas of medium pressure, and an air blowing machine such as a fan or blower that supplies gas of low pressure. The medium pressure is a pressure within a range of from 0.1 MPa to 0.6 MPa, for example. The low pressure is a pressure within a range of from 0.01 MPa to 0.1 MPa, for example. In the present embodiment, as one example, compressed air is supplied by a compressor. The gas supplied to the pipe 13 from the gas supply source 12 carries the abrasive material sent out by the fixed quantity supplying unit 21 to the nozzle 30.

The nozzle 30 sprays, together with the gas, the abrasive material supplied from the storage container 20. The nozzle 30 is housed in a treatment chamber 31, and a solid-gas two-phase flow in which the abrasive material supplied from the storage container 20 and gas are mixed is supplied to the nozzle 30 via the pipe 13. The nozzle 30 sprays, together with the gas, the abrasive material toward a workpiece W disposed in the treatment chamber 31. As a result, blasting is performed on the workpiece W. The workpiece W may be supported by a table that is not shown, and the position may be adjustable by a table driving mechanism.

A lower portion of the treatment chamber 31 is connected to the storage container 20 via the classification mechanism 14. Swarf of the workpiece W and the abrasive material that have fallen down to the lower portion of the treatment chamber 31 are sucked into a dust collector that is not shown and pass through the classification mechanism 14. The classification mechanism 14 classifies reusable abrasive material and other minute powder such as the swarf of the workpiece W and crushed abrasive material. Other minute powder is collected into the dust collector. A lower portion of the classification mechanism 14 is connected to an upper portion of the storage container 20. The reusable abrasive material is supplied to the storage container 20 from the classification mechanism 14. When the abrasive material is not reusable, the blasting apparatus 10 does not necessarily need to include the classification mechanism 14.

The blasting apparatus 10 is controlled by a control apparatus 11. The control apparatus 11 is configured as a programmable logic controller (PLC), for example. The control apparatus 11 may be configured as a computer system including a processor such as a central processing unit (CPU), a memory such as a random access memory (RAM) and a read only memory (ROM), an input-output apparatus such as a touch screen, a mouse, a keyboard, and a display, and a communication apparatus such as a network card. The control apparatus 11 realizes a function of the control apparatus 11 by causing each hardware to operate under the control of the processor based on a computer program stored in the memory.

[Configuration of Electron Beam Irradiation Apparatus]

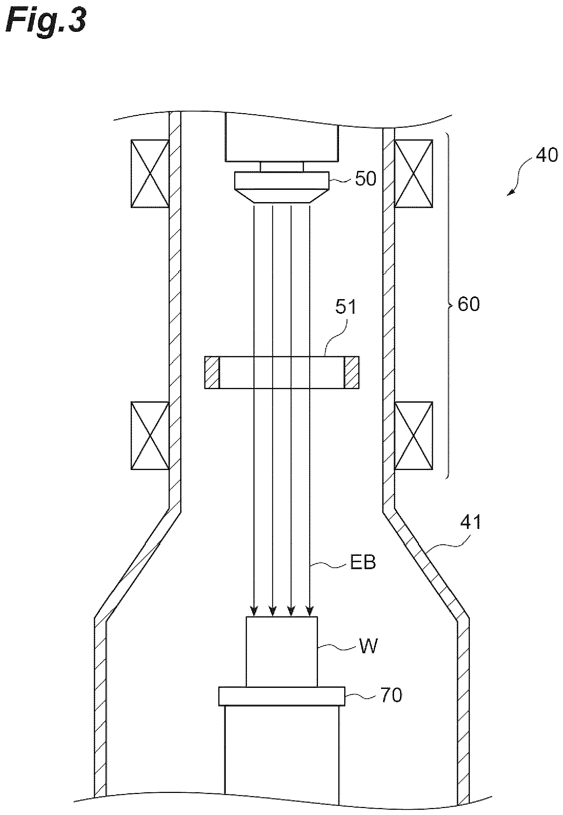

FIG. 3 is a schematic view illustrating one example of an electron beam irradiation apparatus. An electron beam irradiation apparatus 40 illustrated in FIG. 3 is an apparatus that irradiates the workpiece W with electron beam EB and performs surface treatment of the workpiece W. As illustrated in FIG. 3, the electron beam irradiation apparatus 40 includes a vacuum chamber 41, a cathode 50, an anode 51, a pair of solenoids 60, and a stage 70.

The vacuum chamber 41 stores therein the workpiece W irradiated with the electron beam EB and a generation source of the electron beam EB. The workpiece W irradiated with the electron beam is placed on the stage 70 in the vacuum chamber 41. The cathode 50 that is the generation source of the electron beam EB is disposed in the vacuum chamber 41 in such a way as to face the stage 70. The ring-shaped anode 51 is disposed between the stage 70 and the cathode 50. The stage 70, the cathode 50, and the anode 51 are disposed in such a way as to be arranged on one axis in the vacuum chamber 41. Each of the pair of solenoids 60 is a ring-shaped member. The first solenoid is disposed on the outside of the vacuum chamber 41 in such a way as to surround the cathode 50, and the second solenoid is disposed on the outside of the vacuum chamber 41 in such a way as to surround the anode 51.

A vacuum pump that is not shown such as a rotary pump and a turbopump is connected to the vacuum chamber 41. The vacuum chamber 41 is vacuumed in advance when the irradiation with the electron beam EB is performed. Inert gas such as Ar (argon) gas is introduced to the vacuumed vacuum chamber 41 from the outside, and the inside of the vacuum chamber 41 is maintained with an inert gas atmosphere of from about 5 to about $15 \times 10^{-2}$ Pa.

A power source that is not shown that applies pulse voltage is connected to the cathode 50 and the anode 51 stored in the vacuum chamber 41. Another power source that is not shown that is different from the power source connected to the cathode 50 and the anode 51 is connected to the solenoids 60.

When voltage is applied to the solenoids 60, the solenoids 60 generate a magnetic field near the anode 51 in the vacuum chamber 41. When the magnetic field generated near the anode 51 becomes the maximum, a pulse voltage is applied to the anode 51. Electrons in the vacuum chamber 41 move toward the anode 51 to which the voltage has been applied. At this time, the electrons move while drawing a spiral by the Lorentz force because the magnetic field is generated near the anode 51 by the solenoids 60. The electrons repeat collision with gas molecules, and the gas molecules that have collided with the electrons are ionized into positive ions and electrons. The positive ions and the electrons further repeat collision with the gas. A plasma is formed near each of the cathode 50 and the anode 51.

When the plasma generated near the anode 51 becomes the maximum, a pulse voltage is applied to the cathode 50. At this time, the potential difference between the cathode 50 and the plasma near the cathode 50 becomes the maximum. As a result, by the cathode 50 and an electric field in which the plasma is generated near the cathode 50, the electrons emitted from the cathode 50 are accelerated toward the anode 51 and generate the electron beam EB. The electron beam EB passes through the ring-shaped anode 51 and is applied to the workpiece W placed on the stage 70.

A method for surface treatment is described below by referring to FIG. 1 again. First, as performing blasting (Step S10), blasting is performed on the surface of the workpiece by the blasting apparatus 10. As a result, the workpiece surface is physically cut.

Next, as an electron beam irradiating with electron beam(Step S20), the blasted surface of the workpiece is irradiated with electron beam by the electron beam irradiation apparatus 40. Minute unevenness of the surface of the workpiece is molten by the irradiation with the electron beam and is smoothed. Specifically, minute protruding portions are molten by the electron beam and the molten metal flows into minute recessed portions. As a result, the surface of the workpiece is smoothed.

[Surface Treatment System]

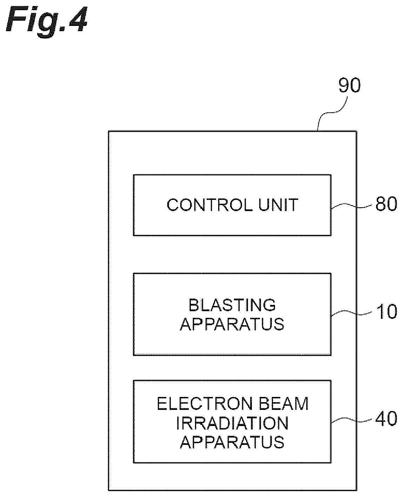

The method for surface treatment illustrated in FIG. 1 may be executed by a surface treatment system. FIG. 4 is a block diagram illustrating one example of a surface treatment system according to the embodiment. As illustrated in FIG. 4, a surface treatment system 90 includes the blasting apparatus 10, the electron beam irradiation apparatus 40, and a control unit 80. The control unit 80 is configured as a PLC as one example and is connected to the blasting apparatus 10 and the electron beam irradiation apparatus 40 in a manner in which communication is possible. The control unit 80 may be configured as the computer system described above. The control unit 80 controls the blasting apparatus 10 and the electron beam irradiation apparatus 40. The blasting apparatus 10 performs blasting on the workpiece W by the control of the control unit 80, and the electron beam irradiation apparatus 40 performs irradiation with the electron beam on the workpiece W on which blasting has been performed by the control of the control unit 80. As described above, the surface treatment system 90 can control each of the blasting apparatus 10 and the electron beam irradiation apparatus 40 and execute the method for surface treatment illustrated in FIG. 1.

[Summary of Embodiment]

In the method for surface treatment according to the present embodiment, the blasted surface of the workpiece W is irradiated with the electron beam. The blasted surface of the workpiece W has a shape that easily melts by the electron beam. As one example, in the blasted surface of the workpiece W, unevenness of 100 μm or more may be physically cut. It can be said that the blasted surface of the workpiece W has a shape that easily melts by the electron beam because the melting speed of the unevenness of 100 μm or more due to the irradiation with the electron beam tends to be slow as compared to unevenness less than 100 μm. In other words, by performing blasting, the method for surface treatment according to the present embodiment can control the surface of the workpiece W to be a shape that easily melts by the electron beam. As a result, as compared to a case where only the irradiation with the electron beam is performed, the reduction rate of the surface roughness of the workpiece increases. Therefore, the method for surface treatment according to the present embodiment can efficiently smooth the workpiece by the irradiation with the electron beam.

The method for surface treatment according to the present embodiment can shorten the time of irradiating with electron beam as compared to a case where only the irradiation with the electron beam is performed even when the workpiece W is a sintered product or an additively manufactured product with relatively high surface roughness. The method for surface treatment according to the present embodiment can also remove, by the electron beam, flaws formed on the surface of the workpiece W by the blasting.

Various exemplary embodiments have been described above, but various omission, replacement, and modifications may be made without being limited to the abovementioned exemplary embodiments. For example, the blasting apparatus 10 is not limited to a direct-pressure-type blasting apparatus and may be a gravity-type air blast apparatus or centrifugal-type blast apparatus. The gravity-type air blast apparatus is a suction-type air blast apparatus in other words.

EXAMPLES

Examples carried out by the inventor of the present invention are described in order to describe the abovementioned effects. The present disclosure is not limited to the examples.

[Production of Workpiece]

As the workpiece W, an additively manufactured product that was a substantially cubic shape in which one edge was 50 mm was prepared. The workpiece W was obtained by performing additive manufacturing with Ti6Al4V ELI powder that is metal powder manufactured by Arcam AB. For the additive manufacturing, Arcam A2X that is an additive manufacturing apparatus manufactured by Arcam AB was used. A number of 16 of the same workpieces W were prepared.

Next, blasting was performed on each of 15 workpieces W out of the 16 workpieces W with use of the blasting apparatus 10 illustrated in FIG. 2 under set blast conditions. As the blast condition, the type of the projection material was steel grids or steel shots, the lower limit value of the hardness of the projection material was from 450 HV to 800 HV, and the granularity was from 0.2 mm to 2.5 mm. As a result, 15 blasted workpieces W and one unblasted workpiece were obtained.

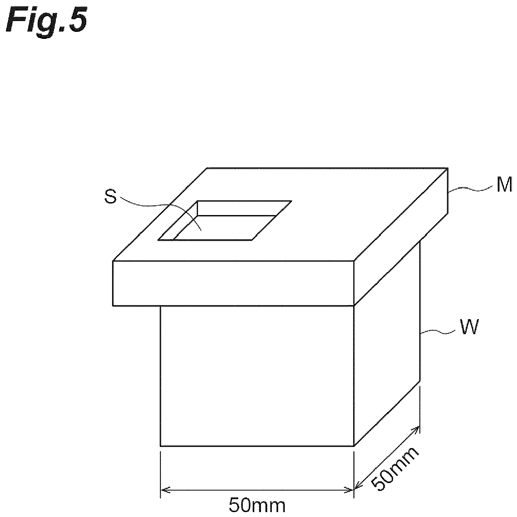

Next, with use of the electron beam irradiation apparatus 40 illustrated in FIG. 3, the surfaces of all of the 16 workpieces W were irradiated with the electron beam EB. FIG. 5 is one example of irradiation with the electron beam performed on the workpieces. As illustrated in FIG. 5, a mask material M was used in order to compare surface states before and after the irradiation with the electron beam EB. The mask material M was a mask made of copper having a 25-mm-square opening S. The workpiece W in a state of being covered with the mask material M was irradiated with the electron beam EB. As the irradiation condition of the electron beam EB, the pulse width was 2 $\mu$s, the pulse frequency was 0.125 Hz, the energy density was 15 J/cm$^2$, and the number of pulse irradiations was 50 times.

[Confirmation of Surface Roughness]

For the 15 blasted workpieces W that are the examples and the unblasted workpiece W that is a comparative example, the surface roughness before and after the electron beam irradiation were confirmed. The surface roughness was evaluated with use of the maximum height roughness Rz ($\mu$m) and the mean width of roughness profile elements RSm ($\mu$m) defined in (Japanese Industrial Standards : JIS B0601: 2001). In other words, RSm ($\mu$m) mean spacing of profile elements. The maximum height roughness Rz ($\mu$m) was the difference between the highest point and the lowest point from the roughness curve of the surface of the workpiece W. The mean width of roughness profile elements RSm ($\mu$m) was the average value of the lengths of contour curve elements in the reference length of the roughness curve of the surface of the workpiece W. The reduction rate (%) of the maximum height roughness Rz was calculated with use of the maximum height roughness Rz ($\mu$m) before and after the irradiation with the electron beam EB. The reduction rate (%) of the maximum height roughness Rz was a rate by which the irradiation with the electron beam EB smoothed the surface of the workpiece W and was calculated by the following expression.

$$\text{Reduction rate (\%) of maximum height roughness } Rz = (1 - \text{Maximum height roughness } Rz \text{ after irradiation with electron beam}/\text{Maximum height roughness } Rz \text{ before irradiation with electron beam}) \times 100$$

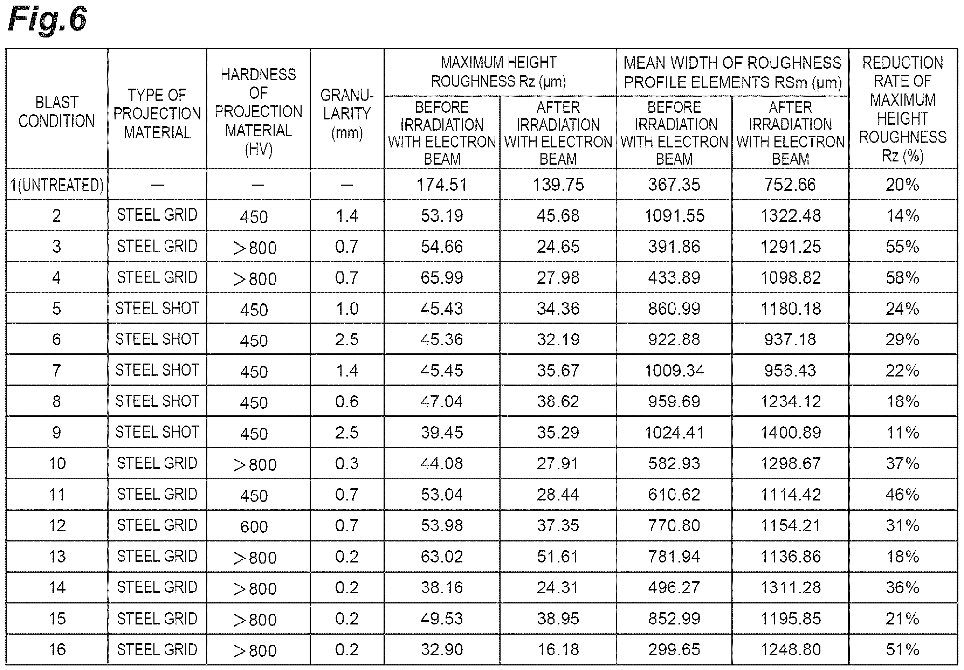

Evaluation results of the surface roughness are shown in FIG. 6. FIG. 6 is a table showing the evaluation results of the surface roughness. A blast condition "1" shown in FIG. 6 is an evaluation result (comparative example) of the surface roughness for the unblasted workpiece W that is the comparative example. Blast conditions "2" to "16" shown in FIG. 6 are evaluation results of the surface roughness for the blasted workpieces W that are the examples.

As shown in the blast condition "1", the Rz of the unblasted workpiece W was 174.51 $\mu$m before the irradiation with the electron beam EB and was reduced to 139.75 $\mu$m after the irradiation with the electron beam EB. In this case, the reduction rate of the Rz was 20%. The RSm was 367.35 $\mu$m before the irradiation with the electron beam EB and increased to 752.66 $\mu$m after the irradiation with the electron beam EB.

In the blast condition "2", the workpiece W was blasted with steel grids, the Vickers hardness of which was 450 HV and granularity was 1.4 mm. The Rz of the blasted workpiece W was 53.19 $\mu$m before the irradiation with the electron beam EB and decreased to 45.68 $\mu$m after the irradiation with the electron beam EB. In this case, the reduction rate of the Rz was 14%. Meanwhile, the RSm was 1091.55 $\mu$m before the irradiation with the electron beam EB and increased to 1322.48 $\mu$m after the irradiation with the electron beam EB.

In the blast condition "3", the workpiece W was blasted with steel grids, the Vickers hardness of which was more than 800 HV and granularity was 0.7 mm. The Rz of the blasted workpiece W was 54.66 $\mu$m before the irradiation with the electron beam EB and decreased to 24.65 $\mu$m after the irradiation with the electron beam EB. In this case, the reduction rate of the Rz was 55%. Meanwhile, the RSm was 391.86 $\mu$m before the irradiation with the electron beam EB and increased to 1291.25 $\mu$m after the irradiation with the electron beam EB.

In the blast condition "4", the workpiece W was blasted with steel grids, the Vickers hardness of which was more than 800 HV and granularity was 0.7 mm. The Rz of the blasted workpiece W was 65.99 $\mu$m before the irradiation

with the electron beam EB and decreased to 27.98 μm after the irradiation with the electron beam EB. In this case, the reduction rate of the Rz was 58%. Meanwhile, the RSm was 433.89 μm before the irradiation with the electron beam EB and increased to 1098.82 μm after the irradiation with the electron beam EB.

In the blast condition "5", the workpiece W was blasted with steel shots, the Vickers hardness of which was 450 HV and granularity was 1.0 mm. The Rz of the blasted workpiece W was 45.43 μm before the irradiation with the electron beam EB and decreased to 34.36 μm after the irradiation with the electron beam EB. In this case, the reduction rate of the Rz was 24%. Meanwhile, the RSm was 860.99 μm before the irradiation with the electron beam EB and increased to 1180.18 μm after the irradiation with the electron beam EB.

In the blast condition "6", the workpiece W was blasted with steel shots, the Vickers hardness of which was 450 HV and granularity was 2.5 mm. The Rz of the blasted workpiece W was 45.36 μm before the irradiation with the electron beam EB and decreased to 32.19 μm after the irradiation with the electron beam EB. In this case, the reduction rate of the Rz was 29%. Meanwhile, the RSm was 922.88 μm before the irradiation with the electron beam EB and increased to 937.18 μm after the irradiation with the electron beam EB.

In the blast condition "7", the workpiece W was blasted with steel shots, the Vickers hardness of which was 450 HV and granularity was 1.4 mm. The Rz of the blasted workpiece W was 45.45 μm before the irradiation with the electron beam EB and decreased to 35.67 μm after the irradiation with the electron beam EB. In this case, the reduction rate of the Rz was 22%. Meanwhile, the RSm was 1009.34 μm before the irradiation with the electron beam EB and decreased to 956.43 μm after the irradiation with the electron beam EB.

In the blast condition "8", the workpiece W was blasted with steel shots, the Vickers hardness of which was 450 HV and granularity was 0.6 mm. The Rz of the blasted workpiece W was 47.04 μm before the irradiation with the electron beam EB and decreased to 38.62 μm after the irradiation with the electron beam EB. In this case, the reduction rate of the Rz was 18%. Meanwhile, the RSm was 959.69 μm before the irradiation with the electron beam EB and increased to 1234.12 μm after the irradiation with the electron beam EB.

In the blast condition "9", the workpiece W was blasted with steel shots, the Vickers hardness of which was 450 HV and granularity was 2.5 mm. The Rz of the blasted workpiece W was 39.45 μm before the irradiation with the electron beam EB and decreased to 35.29 μm after the irradiation with the electron beam EB. In this case, the reduction rate of the Rz was 11%. Meanwhile, the RSm was 1024.41 μm before the irradiation with the electron beam EB and increased to 1400.89 μm after the irradiation with the electron beam EB.

In the blast condition "10", the workpiece W was blasted with steel grids, the Vickers hardness of which was more than 800 HV and granularity was 0.3 mm. The Rz of the blasted workpiece W was 44.08 μm before the irradiation with the electron beam EB and decreased to 27.91 μm after the irradiation with the electron beam EB (the reduction rate of the Rz was 37%.) Meanwhile, the RSm was 582.93 μm before the irradiation with the electron beam EB and increased to 1298.67 μm after the irradiation with the electron beam EB.

In the blast condition "11", the workpiece W was blasted with steel grids, the Vickers hardness of which was 450 HV and granularity was 0.7 mm. The Rz of the blasted workpiece W was 53.04 μm before the irradiation with the electron beam EB and decreased to 28.44 μm after the irradiation with the electron beam EB. In this case, the reduction rate of the Rz was 46%. Meanwhile, the RSm was 610.62 μm before the irradiation with the electron beam EB and increased to 1114.42 μm after the irradiation with the electron beam EB.

In the blast condition "12", the workpiece W was blasted with steel grids, the Vickers hardness of which was 600 HV and granularity was 0.7 mm. The Rz of the blasted workpiece W was 53.98 μm before the irradiation with the electron beam EB and decreased to 37.35 μm after the irradiation with the electron beam EB. In this case, the reduction rate of the Rz was 31%. Meanwhile, the RSm was 770.80 μm before the irradiation with the electron beam EB and increased to 1154.21 μm after the irradiation with the electron beam EB.

In the blast condition "13", the workpiece W was blasted with steel grids, the Vickers hardness of which was more than 800 HV and granularity was 0.2 mm. The Rz of the blasted workpiece W was 63.02 μm before the irradiation with the electron beam EB and decreased to 51.61 μm after the irradiation with the electron beam EB. In this case, the reduction rate of the Rz was 18%. Meanwhile, the RSm was 781.94 μm before the irradiation with the electron beam EB and increased to 1136.86 μm after the irradiation with the electron beam EB.

In the blast condition "14", the workpiece W was blasted with steel grids, the Vickers hardness of which was more than 800 HV and granularity was 0.2 mm. The Rz of the blasted workpiece W was 38.16 μm before the irradiation with the electron beam EB and decreased to 24.31 μm after the irradiation with the electron beam EB. In this case, the reduction rate of the Rz was 36%. Meanwhile, the RSm was 496.27 μm before the irradiation with the electron beam EB and increased to 1311.28 μm after the irradiation with the electron beam EB.

In the blast condition "15", the workpiece W was blasted with steel grids, the Vickers hardness of which was more than 800 HV and granularity was 0.2 mm. The Rz of the blasted workpiece W was 49.53 μm before the irradiation with the electron beam EB and decreased to 38.95 μm after the irradiation with the electron beam EB. In this case, the reduction rate of the Rz was 21%. Meanwhile, the RSm was 852.99 μm before the irradiation with the electron beam EB and increased to 1195.85 μm after the irradiation with the electron beam EB.

In the blast condition "16", the workpiece W was blasted with steel grids, the Vickers hardness of which was more than 800 HV and granularity was 0.2 mm. The Rz of the blasted workpiece W was 32.90 μm before the irradiation with the electron beam EB and decreased to 16.18 μm after the irradiation with the electron beam EB. In this case, the reduction rate of the Rz was 51%. Meanwhile, the RSm was 299.65 μm before the irradiation with the electron beam EB and increased to 1248.80 μm after the irradiation with the electron beam EB.

As shown in FIG. 6, in the workpieces W blasted under the blast conditions "2" to "16", the Rz after the irradiation with the electron beam EB was within the range of from 16.18 μm to 51.61 μm. Meanwhile, in the unblasted workpiece W on which only the irradiation with the electron beam EB was performed, the Rz after the irradiation with the electron beam EB was 139.75 μm. Therefore, it was confirmed that the surface of the workpiece W can be further smoothed by irradiating the surface of the workpiece W on which the blasting was performed with the electron beam EB.

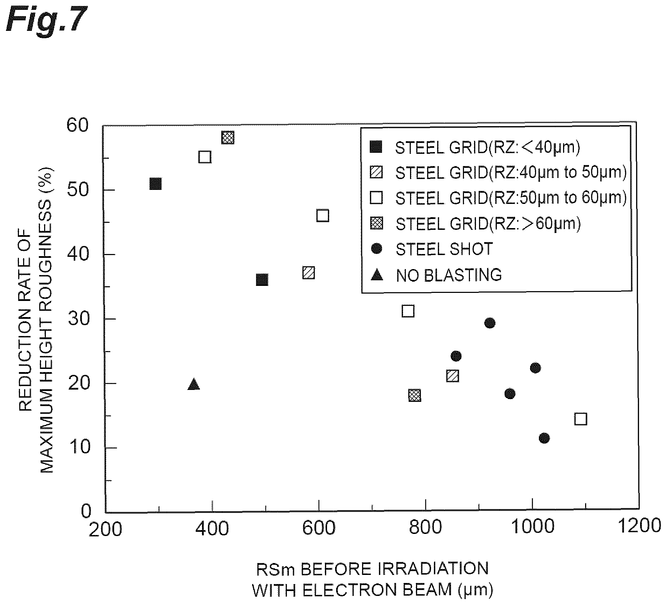

The correlation between the RSm before the irradiation with the electron beam EB and the reduction rate of the Rz due to the irradiation with the electron beam EB was confirmed on the basis of the results of FIG. 6. FIG. 7 is a scatter diagram showing the correlation between the RSm and the reduction rate of the Rz. The abscissa is the RSm before the irradiation with the electron beam EB and the ordinate is the reduction rate of the Rz. In FIG. 7, data is shown by classifying the data into six data: no blasting (the blast condition "1"); blasting with steel shots (the blast conditions "5" to "9"); the Rz after the blasting with steel grids being less than 40 μm (the blast conditions "9" and "16"); the Rz after the blasting with steel grids being from 40 μm to 50 μm (the blast conditions "10" and "15"); the Rz after the blasting with steel grids being from 50 μm to 60 μm (the blast conditions "2", "3", "11", and "12"); and the Rz after the blasting with steel grids being 60 μm or more in accordance with the blast conditions.

As shown in FIG. 7, a correlative relationship in which the reduction rate of the Rz rises when the RSm becomes smaller was confirmed. It was confirmed that a condition in which the blasting is performed and Rsm is less than 770.80 μm needs to be satisfied in order to realize the reduction rate of the Rz that is 20% or more. The Rz reduction rates of all of the blasted workpieces W (the blast conditions "3", "4", and "16") that each had the RSm that was in the same range as the RSm of the unblasted workpiece W were more than twice as high as that of the unblasted workpiece W. From the above, it was presumed that the blasted surface was controlled to be a shape that easily melts by the electron beam in parameters other than the RSm that was evaluated this time.

[Cross-section Observation of Surface]

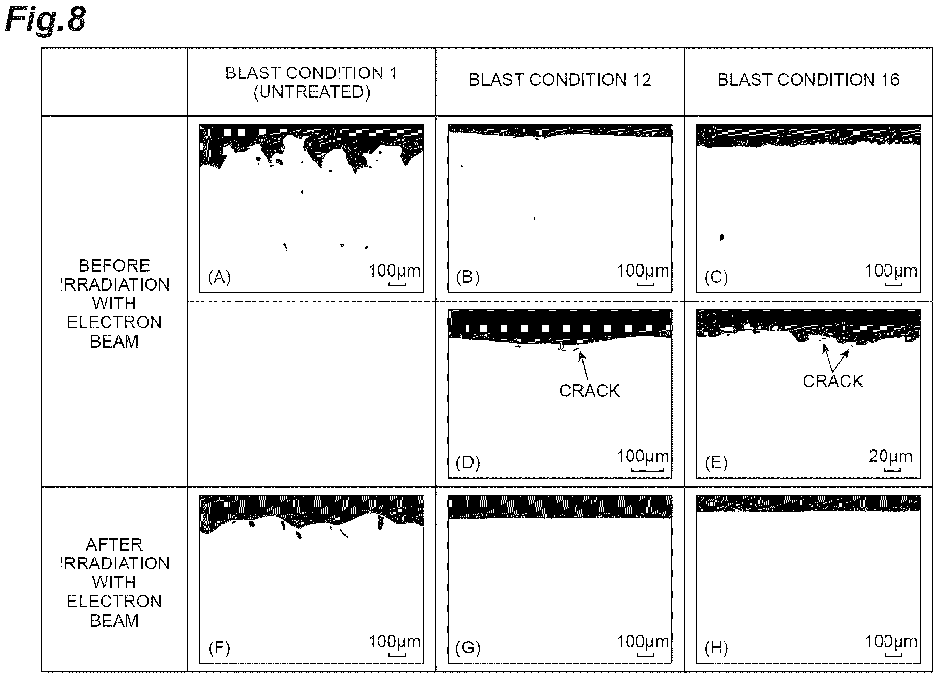

FIGS. 8A to 8E are cross-section observation results of the workpieces W before the irradiation with the electron beam EB. FIG. 8A is an observation result (the blast condition "1") of the unblasted workpiece W, and FIGS. 8B and 8D are observation results (the blast condition "12") of the blasted workpiece W. FIG. 8D is an enlarged view of FIG. 8B. FIGS. 8C and 8E are observation results (the blast condition "16") of the blasted workpiece W. FIG. 8E is an enlarged view of FIG. 8C. As shown in FIG. 8A, in the unblasted workpiece W, minute unevenness of 100 μm or less and large unevenness more than 100 μm were confirmed. Meanwhile, as shown in FIGS. 8B to 8E, in the blasted workpieces W, unevenness more than 100 μm did not exist. Therefore, it was confirmed that unevenness more than 100 μm was removed and flattened by the blasting. As shown in FIGS. 8D and 8E, it was confirmed that there were cracks that were about 20 μm in the surface of the blasted workpieces W.

FIGS. 8F to 8H are cross-section observation results after the irradiation with the electron beam EB. FIG. 8F is an observation result after the workpiece according to FIG. 8A was irradiated with the electron beam EB. FIG. 8G is an observation result after the workpiece W according to FIGS. 8B and 8D was irradiated with the electron beam EB. FIG. 8H is an observation result after the workpiece W according to FIGS. 8C and 8E was irradiated with the electron beam EB. As shown in FIG. 8F, by the irradiation with the electron beam EB, the minute unevenness that was 100 μm or less confirmed before the irradiation with the electron beam EB was removed. Meanwhile, unevenness more than 100 μm was not completely removed and remained even when the electron beam EB was applied. As a result, it was confirmed that the irradiation with the electron beam EB was not able to efficiently remove unevenness more than 100 μm. Meanwhile, as shown in FIGS. 8G and 8H, the blasted workpieces W were extremely flattened by the electron beam irradiation. It was confirmed that the blasted surfaces as those shown in FIGS. 8B to 8E had shapes that easily melt by the electron beam because unevenness more than 100 μm did not exist.

By the above, it was confirmed that the blasting was able to remove unevenness more than 100 μm that was not able to be removed by the irradiation with the electron beam EB. In other words, it was confirmed that the blasting was able to control the surface to be a shape that easily melts by the electron beam. Therefore, it was confirmed that the method for surface treatment that performs the irradiation with the electron beam EB after performing blasting was able to efficiently smooth the surface of the workpiece W. It was confirmed that the irradiation with the electron beam EB was able to remove cracks caused by the blasting.

Reference Signs List

10···Blasting apparatus, 40···Electron beam irradiation apparatus, 80···Control unit, 90···Surface treatment system, EB···Electron beam, W···Workpiece.

**Claims**

1. A method for surface treatment, the method comprising:

   performing blasting on a surface of a workpiece; and
   irradiating the blasted surface of the workpiece with electron beam.

2. The method for surface treatment according to claim 1, wherein the workpiece is a sintered product of metal powder.

3. The method for surface treatment according to claim 2, wherein the workpiece is an additively manufactured product.

4. The method for surface treatment according to claim 1 or 2, wherein a mean width of roughness profile elements of the blasted surface of the workpiece is less than 770.80 $\mu$m.

5. A surface treatment system, comprising:

   a blasting apparatus configured to perform blasting on a workpiece;
   an electron beam irradiation apparatus configured to irradiate the workpiece with electron beam; and
   a control unit configured to control the blasting apparatus and the electron beam irradiation apparatus, wherein the control unit causes the blasting apparatus to perform blasting on a surface of the workpiece by controlling the blasting apparatus, and causes the electron beam irradiation apparatus to irradiate, with the electron beam, the surface of the blasted workpiece by controlling the electron beam irradiation apparatus.

# Fig.1

```
        ┌─────────────┐
        │    START    │
        └──────┬──────┘
               │
               ▼
   ┌───────────────────────┐
   │  PERFORMING BLASTING  │──── S10
   └───────────┬───────────┘
               │
               ▼
   ┌───────────────────────┐
   │   IRRADIATING WITH    │──── S20
   │    ELECTRON BEAM      │
   └───────────┬───────────┘
               │
               ▼
        ┌─────────────┐
        │     END     │
        └─────────────┘
```

# Fig.2

CONTROL APPARATUS — 11

10

14

30

31

20

12

21

13

# Fig.3

*Fig.4*

90

CONTROL UNIT —— 80

BLASTING
APPARATUS —— 10

ELECTRON BEAM
IRRADIATION
APPARATUS —— 40

# *Fig.5*

# Fig.6

| BLAST CONDITION | TYPE OF PROJECTION MATERIAL | HARDNESS OF PROJECTION MATERIAL (HV) | GRANU-LARITY (mm) | MAXIMUM HEIGHT ROUGHNESS Rz (μm) | | MEAN WIDTH OF ROUGHNESS PROFILE ELEMENTS RSm (μm) | | REDUCTION RATE OF MAXIMUM HEIGHT ROUGHNESS Rz (%) |
|---|---|---|---|---|---|---|---|---|
| | | | | BEFORE IRRADIATION WITH ELECTRON BEAM | AFTER IRRADIATION WITH ELECTRON BEAM | BEFORE IRRADIATION WITH ELECTRON BEAM | AFTER IRRADIATION WITH ELECTRON BEAM | |
| 1(UNTREATED) | — | — | — | 174.51 | 139.75 | 367.35 | 752.66 | 20% |
| 2 | STEEL GRID | 450 | 1.4 | 53.19 | 45.68 | 1091.55 | 1322.48 | 14% |
| 3 | STEEL GRID | >800 | 0.7 | 54.66 | 24.65 | 391.86 | 1291.25 | 55% |
| 4 | STEEL GRID | >800 | 0.7 | 65.99 | 27.98 | 433.89 | 1098.82 | 58% |
| 5 | STEEL SHOT | 450 | 1.0 | 45.43 | 34.36 | 860.99 | 1180.18 | 24% |
| 6 | STEEL SHOT | 450 | 2.5 | 45.36 | 32.19 | 922.88 | 937.18 | 29% |
| 7 | STEEL SHOT | 450 | 1.4 | 45.45 | 35.67 | 1009.34 | 956.43 | 22% |
| 8 | STEEL SHOT | 450 | 0.6 | 47.04 | 38.62 | 959.69 | 1234.12 | 18% |
| 9 | STEEL SHOT | 450 | 2.5 | 39.45 | 35.29 | 1024.41 | 1400.89 | 11% |
| 10 | STEEL GRID | >800 | 0.3 | 44.08 | 27.91 | 582.93 | 1298.67 | 37% |
| 11 | STEEL GRID | 450 | 0.7 | 53.04 | 28.44 | 610.62 | 1114.42 | 46% |
| 12 | STEEL GRID | 600 | 0.7 | 53.98 | 37.35 | 770.80 | 1154.21 | 31% |
| 13 | STEEL GRID | >800 | 0.2 | 63.02 | 51.61 | 781.94 | 1136.86 | 18% |
| 14 | STEEL GRID | >800 | 0.2 | 38.16 | 24.31 | 496.27 | 1311.28 | 36% |
| 15 | STEEL GRID | >800 | 0.2 | 49.53 | 38.95 | 852.99 | 1195.85 | 21% |
| 16 | STEEL GRID | >800 | 0.2 | 32.90 | 16.18 | 299.65 | 1248.80 | 51% |

# Fig.7

Fig.8

Europäisches
Patentamt

European
Patent Office

Office européen
des brevets

# EUROPEAN SEARCH REPORT

**Application Number**

EP 22 15 8196

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 10 2017 107319 B3 (WKW ERBSLOEH AUTOMOTIVE GMBH [DE]) 21 June 2018 (2018-06-21) | 1,4,5 | INV. B24C1/06 B23K26/354 B33Y40/20 B22F10/64 B22F10/66 B23K26/00 |
| Y | * paragraphs [0005], [0006], [0010] * ----- | 2,3 | |
| X | US 2008/233838 A1 (MASE KEIJI [JP] ET AL) 25 September 2008 (2008-09-25) * paragraphs [0112], [0113] * ----- | 1 | |
| Y | US 2018/333782 A1 (GALLAGHER MICHELLE B [US] ET AL) 22 November 2018 (2018-11-22) * paragraphs [0005], [0006] * ----- | 2,3 | ADD. B24C9/00 B24C11/00 |
| A | US 10 807 214 B2 (UNITED TECHNOLOGIES CORP [US]; RAYTHEON TECH CORP [US]) 20 October 2020 (2020-10-20) * column 3, line 57 - line 67 * ----- | 5 | |

| TECHNICAL FIELDS SEARCHED (IPC) |
|---|
| B24C B23K B33Y C22C B22F |

The present search report has been drawn up for all claims

| Place of search | Date of completion of the search | Examiner |
|---|---|---|
| The Hague | 21 June 2022 | Beltzung, J |

EPO FORM 1503 03.82 (P04C01)

## ANNEX TO THE EUROPEAN SEARCH REPORT
## ON EUROPEAN PATENT APPLICATION NO.

EP 22 15 8196

This annex lists the patent family members relating to the patent documents cited in the above-mentioned European search report.
The members are as contained in the European Patent Office EDP file on
The European Patent Office is in no way liable for these particulars which are merely given for the purpose of information.

21-06-2022

| Patent document cited in search report | Publication date | Patent family member(s) | Publication date |
|---|---|---|---|
| DE 102017107319 B3 | 21-06-2018 | NONE | |
| US 2008233838 A1 | 25-09-2008 | CN 101269479 A | 24-09-2008 |
| | | DE 102008014490 A1 | 09-10-2008 |
| | | JP 5171082 B2 | 27-03-2013 |
| | | JP 2008229809 A | 02-10-2008 |
| | | KR 20080086820 A | 26-09-2008 |
| | | US 2008233838 A1 | 25-09-2008 |
| US 2018333782 A1 | 22-11-2018 | AU 2016355577 A1 | 24-05-2018 |
| | | CA 3005757 A1 | 26-05-2017 |
| | | CN 108472407 A | 31-08-2018 |
| | | EP 3377123 A1 | 26-09-2018 |
| | | JP 2018535811 A | 06-12-2018 |
| | | TW 201739476 A | 16-11-2017 |
| | | US 2018333782 A1 | 22-11-2018 |
| | | WO 2017087927 A1 | 26-05-2017 |
| | | ZA 201804093 B | 25-11-2020 |
| US 10807214 B2 | 20-10-2020 | EP 3498425 A1 | 19-06-2019 |
| | | US 2019184521 A1 | 20-06-2019 |

EPO FORM P0459

For more details about this annex : see Official Journal of the European Patent Office, No. 12/82

**REFERENCES CITED IN THE DESCRIPTION**

**Patent documents cited in the description**

- JP 2021029702 A
- JP 2004001086 A